Europäisches Patentamt

European Patent Office

Office européen des brevets

(11) Publication number: **0 316 481**
**A1**

(12) **EUROPEAN PATENT APPLICATION**

(21) Application number: **87118675.5**

(22) Date of filing: **16.12.87**

(51) Int. Cl.⁴: **H05K 11/02 , H04B 1/08 ,**
**H05K 7/14 , G06F 13/40**

(30) Priority: **20.11.87 US 123291**

(43) Date of publication of application:
**24.05.89 Bulletin 89/21**

(84) Designated Contracting States:
**DE ES FR GB IT**

(71) Applicant: **Chae, Suk**
**35-2, Nowon-Dong 3-Ka, Bukgu**
**Daegu-shi(KR)**

(72) Inventor: **Chae, Suk**
**35-2, Nowon-Dong 3-Ka, Bukgu**
**Daegu-shi(KR)**

(74) Representative: **Patentanwälte Kirschner &**
**Grosse**
**Forstenrieder Allee 59**
**D-8000 München 71(DE)**

(54) **Portable audio system containing a car audio assembly.**

(57) A portable audio system apparatus comprises a speaker box containing a plurality of speakers, an insertion space disposed therein for being inserted a car audio assembly from a car so that the portable audio system has dual functions as a audio system and a shutter of the car audio assembly.

*FIG I*

EP 0 316 481 A1

## BACKGROUND OF THE INVENTION

1. Field of the Invention

The present invention relates to a portable audio system containing a car audio assembly for attaching thereto and detaching therefrom. More particularly, the present invention relates to a portable audio set which contains a car audio assembly which is detachable from the car. That is, the car audio assembly is detached from the car and the car audio assembly is attached to the portable audio set to form a complete portable audio set for removing the car audio assembly from the car and thereby preventing it from being stolen from the car.

2. Description of the Prior Art

A typical conventional car audio assembly includes a car radio, a car stereo cassette player, a compact disc player, and other audio apparatus, while the speakers are separately provided in the car, so that, when the car audio system is installed, the system is connected to the speakers to form a complete audio system.

Since some expensive car audio systems are tightly mounted in the car, they used to be stolen.

In order to avoid such thefts, detachable car audio systems have appeared recently. When the car is parked for a long period of time, the driver can detach the audio system to carry it along with him or to store it in some safe place. However, such a conventional detachable audio system is not integrally provided with speakers therein and cannot be used outside of the car.

SUMMARY OF THE INVENTION

Accordingly, it is an object of the present invention to provide a portable speaker system box which includes a plurality of speakers and an insertion space for accommodating a car audio assembly. The car audio assembly contains a car radio, a car stereo cassette player, and other audio apparatuses.

Another object of the present invention is to provide the portable speaker system to form a complete audio system by inserting the car audio assembly, which is removed from the car, into the portable speaker system of the present invention for connecting the audio assembly to the speaker lines, the antenna line and the power source. The car audio assembly in the portable speaker system is operated by means of a power source such as an AC or a DC source.

A further object of the present invention is to provide a portable audio system for carrying a car audio assembly disposed therein. Therefore, the device of the present invention not only provides a protective means for an expensive car audio assembly, but also allows for a complete second audio system which may be used outside the car.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the spirit and scope of the invention will become apparent to those skilled in the art from this detailed description.

Briefly described, the present invention relates to a portable speaker system box including an insertion space adapted for insertion of a car audio assembly which is removed from a car thereby preventing the car audio assembly from being stolen from the car and completing an audio system for use outside the car by inserting the car audio assembly into the speaker box so that it is operatively associated therewith.

BRIEF DESCRIPTION OF THE DRAWINGS

The present invention will become more fully understood from the detailed description given hereinbelow and the accompanying drawings which are given by way of illustration only, and thus are not limitative of the present invention, and wherein:

Fig. 1 is a perspective view of the speaker system box apparatus of the present invention into which is inserted the car audio assembly;

Fig. 2 is an exemplary illustration of the detachability of the car audio assembly from the car, and the combinability of the car audio assembly with the portable speaker box apparatus of the present invention; and

Fig. 3 is a plan view of the portable speaker box apparatus containing the car audio assembly of the present invention containing cut-away portions in order to illustrate the construction of various elements of the apparatus of the present invention.

DETAILED DESCRIPTION OF THE INVENTION

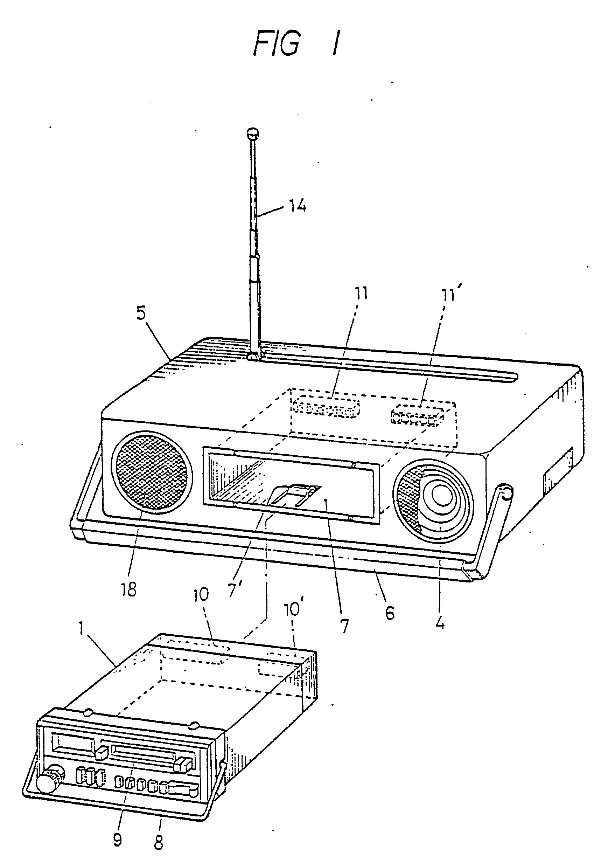

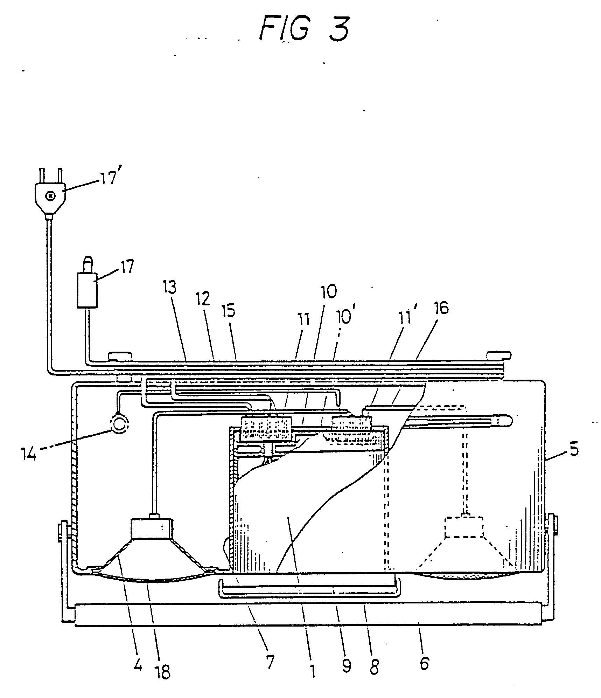

Referring now in detail to the drawings for the purpose of illustrating preferred embodiments of the present invention, the portable audio system apparatus 5 as shown in Figs. 1 and 3 according to the present invention comprises a plurality of speakers 4, an insertion space 7, a handle 6 and an antenna 14. The insertion space 7 is adapted for insertion of a car audio assembly.

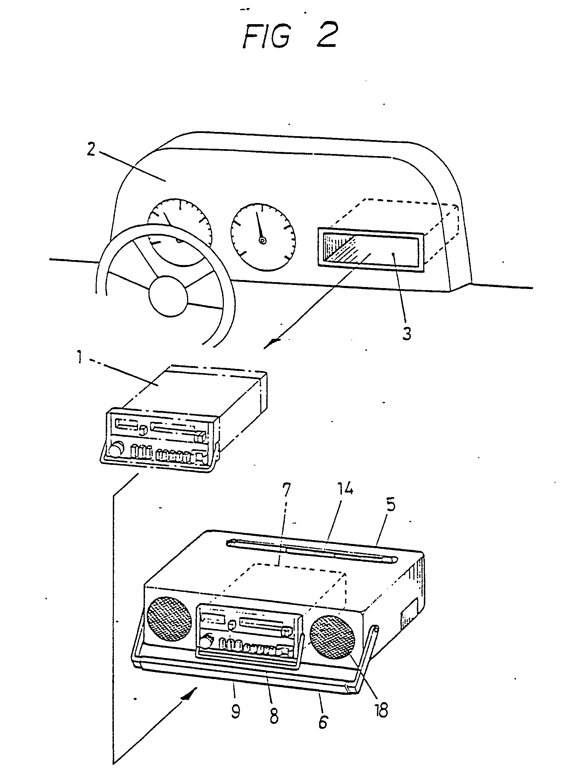

The car audio assembly 1 as shown in Figs. 1 and 2 includes in a known manner a car radio, a car stereo, a cassette player, a car DAT player, a car CD player, and the like. The car audio assembly 1 is a detachable type. The car audio assembly 1 may be inserted into a car insertion space 3 disposed on the front panel 2 of the car. Connector plugs 10' provided on the car audio assembly 1 are connected to the speaker lines (not shown) which are provided in the car. Also, connector plugs 10 provided on the car audio assembly 1 are connected to the power supply line and the antenna (not shown) which are also provided in the car. The car audio assembly 1 is provided with a control member 9 for easy operating. When the car is left alone, the car audio assembly 1 can be separated out of the car insertion space 3 by simply pulling out a handle 8, thereafter the car audio assembly 1 can be carried away or moved to some safe place (Fig. 2).

In order to advantageously utilize such a detachable car audio assembly 1 as a portable operable audio system as shown in Fig. 3, the speaker system box apparatus 5 according to the present invention is provided with the plurality of speakers 4, the speakers being protected with a protection net 18, respectively. The speaker system box apparatus 5 is also provided with the handle 6 for handling, the handle 6 being attached onto the opposite sides of the speaker system apparatus 5. The insertion space 7 is located in the middle portion.

The insertion space 7 is a hollow space with a rectangular cross section, and has a plurality of elastic holders 7' therein to retain the car audio assembly 1 with an adequate pressure when the car audio assembly 1 is inserted into the insertion space 7. Therefore, as long as an intentional force is not applied to separate the two units, the speaker system box apparatus 5 and car audio assembly 1 are tightly associated with each other.

As shown in Fig. 3, the insertion space 7 is provided with connector sockets 11 and 11' disposed at the bottom thereof which can be respectively connected to connector plugs 10 and 10' provided on the back of the car audio system 1. The connector socket 11' is connected to a line 16 of the speakers 4, while the connector socket 11 is connected to a DC power source cord 12, an AC power source cord 13, and the line of an antenna 14 internally. These connectors are installed in a proper arrangement so that they can fit in the counterpart pairs of connectors, depending on the type of the car audio assembly used.

The speaker system box apparatus 5 is provided with plugs 17 and 17' connected to the ends of a DC power source cord 12 and AC power source cord 13, respectively. However, the speaker system box apparatus 5 alone does not function as an audio apparatus. Only after insertion of the car audio assembly 1 into the insertion space 7 of the speaker system box apparatus 5 is the whole assembly completed so as to function as an audio system, and the car audio assembly 1 is transformed into a portable audio system. Thus, the whole assembly in which the car audio assembly 1 and the speaker system box 5 are combined can be carried along by holding the handle 6 of the speaker system box apparatus 5.

After the combination of the speaker system box apparatus 5 and the car audio assembly 1, the control member 9 for the car audio assembly 1 is exposed, and therefore, the operation of the car audio assembly 1 can be controlled in the same way as when the car audio assembly 1 is installed in the car. In a place such as a home, the combined system can be used by connecting the plug 17' of the AC power source cord 13 to the home power source, while in such a place as an open field where the car is driven, the combined system can be used by connecting the plug 17 of the DC power source cord 12 to the power source socket formed in the car, or to a separate power source such as a dry cell.

The internal constitution of the insertion space 7 formed in the speaker system box apparatus 5 of the present invention is quite similar to the internal constitution of the insertion space 3 formed in the car. However, if necessary, the speaker system box apparatus 5 according to the present invention can be provided additionally with an external speaker line, an ear phone line, other audio components, etc. It is also contemplated that a small television set may be added to the speaker system box apparatus 5 of the present invention.

The portable audio system apparatus according to the present invention performs dual functions when it is operatively associated with a car audio assembly. That is, providing for a portable means of playing the audio assembly and protecting the car audio assembly from theft from an unoccupied car which is especially advantageous for expensive audio assemblies.

The invention being thus described, it will be obvious that the same may be varied in many ways. Such variations are not to be regarded as a departure from the spirit and scope of the invention, and all such modifications as would be obvious to one skilled in the art are intended to be included in the scope of the following claims.

## Claims

1. A portable audio system apparatus comprising:

a speaker box containing a plurality of speakers, said speaker box having an insertion space disposed therein for operatively receiving a car audio assembly,

connector sockets disposed in said insertion space, said connector sockets being operatively connected to said plurality of speakers, wherein said connector sockets operatively receive connector plugs disposed on said car audio assembly,

an antenna operatively connected to said speaker box, and a handle operatively connected to said speaker box,

wherein said portable audio system apparatus is fully operational upon insertion of said car audio assembly into said speaker box.

2. The portable audio system of claim 1, wherein said insertion space is provided with elastic holders disposed therein for elastically retaining said car audio assembly.

3. The portable audio system of claim 1, wherein said speaker box is further provided with power source cords operatively connected thereto.

4. The portable audio system of claim 1, wherein speaker box is provided with jacks for insertion of the plug of an external speaker, an earphone, other audio accessories, a small TV set, or combinations thereof.

5. The portable audio system of claim 1 wherein the car audio assembly comprises a car radio, a car stereo, a cassette player, a car DAT play, a car CD player, or combinations thereof.

6. A portable audio system apparatus comprising:

a speaker box containing a plurality of speakers, said speaker box having an insertion space disposed therein,

connector sockets disposed in said insertion space, said connector sockets being operatively connected to said plurality of speakers,

a car audio assembly for being inserted into said insertion space, said car audio assembly having connector plugs operatively disposed thereon for connecting to said connector sockets upon insertion of said car audio assembly into said insertion space,

an antenna operatively connected to said speaker box, and a handle operatively connected to said speaker box,

wherein upon insertion of said car audio assembly into said speaker box said car audio assembly is fully operational in said portable audio system apparatus.

7. The portable audio system of claim 6, wherein said insertion space is provided with elastic holders disposed therein for elastically retaining said car audio assembly.

8. The portable audio system of claim 6, wherein said speaker box is further provided with power source cords operatively connected thereto.

9. The portable audio system of claim 6, wherein speaker box is provided with jacks for insertion of the plug of an external speaker, an earphone, other audio accessories, a small TV set, or combinations thereof.

10. The portable audio system of claim 6 wherein the car audio assembly comprises a car radio, a car stereo, a cassette player, a car DAT play, a car CD player, or combinations thereof.

# FIG I

# FIG 2

# FIG 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 522 599 (COLOMBIER)<br>* Page 1, line 19 - page 2, line 4;<br>page 2, lines 21-39; figure 1 * | 1,3-5 | H 05 K 11/02<br>H 04 B 1/08<br>H 05 K 7/14<br>G 06 F 13/40 |
| Y | | 2,6-10 | |
| X | WO-A-8 603 080 (PLEAU)<br>* Claims 1-5; figures 1,2 * | 1,3 | |
| Y | US-A-4 326 653 (STONE)<br>* Column 6, lines 48-64; figures 14-15 * | 2,7 | |
| Y | DE-A-3 320 964 (LUTZ)<br>* Claim 1; figures 6,14 * | 6-10 | |

TECHNICAL FIELDS SEARCHED (Int. Cl.4)

H 05 K
B 60 R

The present search report has been drawn up for all claims

| Place of search | Date of completion of the search | Examiner |
|---|---|---|
| THE HAGUE | 02-02-1989 | BARANSKI I. |

EPO FORM 1503 03.82 (P0401)